**Europäisches Patentamt**

**European Patent Office**

**Office européen des brevets**

(19)

(11) Veröffentlichungsnummer: **0 264 762 B1**

# EUROPÄISCHE PATENTSCHRIFT

(12)

(45) Veröffentlichungstag der Patentschrift: **25.03.92**

(51) Int. Cl.5: **H01L 21/324**, H01L 31/18

(21) Anmeldenummer: **87114872.2**

(22) Anmeldetag: **12.10.87**

(54) Verfahren zur Passivierung von Kristalldefekten in einem Wasserstoffplasma.

(30) Priorität: **24.10.86 DE 3636340**

(43) Veröffentlichungstag der Anmeldung:
**27.04.88 Patentblatt 88/17**

(45) Bekanntmachung des Hinweises auf die
Patenterteilung:
**25.03.92 Patentblatt 92/13**

(84) Benannte Vertragsstaaten:
**BE DE FR GB IT NL**

(56) Entgegenhaltungen:
**US-A- 4 343 830**

**JAPANESE JOURNAL OF APPLIED PHYSICS,
Band 22, Nr. 1, Teil 2, Januar 1983, Seiten
L34-L36, Tokyo, JP; A. MATSUDA et al.:
"Wide-range control of crystallite size and
its orientation in glow-discharge deposited
muc Si:H"**

**PATENT ABSTRACTS OF JAPAN, BAnd 6, Nr.
189 (E-133)[1067], 28. September 1982; & JP-
A-57 102 027**

**Idem**

(73) Patentinhaber: **SIEMENS AKTIENGESELL-
SCHAFT
Wittelsbacherplatz 2
W-8000 München 2(DE)**

(72) Erfinder: **Grasser, Heinrich, Dipl.-Phys.
Uppenbornstrasse 30
W-8000 München 83(DE)**
Erfinder: **Münzer, Alois, Dipl.-Phys.
Orleansstrasse 67
W-8000 München 80(DE)**

APPLIED PHYSICS LETTERS, Band 35, Nr. 7, 1. Oktober 1979, Seiten 551-552, American Institute of Physics, New York, US; T. MAKINO et al.: "The influence of plasma annealing on electrical properties of polycrystalline Si"

APPLIED PHYSICS LETTERS, Band 41, Nr. 11, 1. Dezember 1982, Seiten 1078-1080, American Institute of Physics, New York, US; J. LAGOWSKI et al.: "Passivation of the dominant deep level (EL2) in GaAs by hydrogen"

APPLIED PHYSICS LETTERS, Band 47, Nr. 2, 15. Juli 1985, Seiten 138-140, American Institute of Physics, New York, US; S. CANNAVO et al.: "Ion beam and temperature annealing during high dose implants"

IEEE ELECTRON DEVICE LETTERS, Band EDL-6, Nr. 3, März 1985, Seiten 139-142, IEEE, New York, US; H.J. SINGH et al.: "Hydrogenation by ion implantation for scaled SOI/PMOS transistors"

JOURNAL OF APPLIED PHYSICS, Band 57, Nr. 12, 15. Juni 1985, Seiten 5275-5278, American Institute of Physics, New York, US; J.M. HWANG et al.: "Deep levels introduced into silicon during hydrogen plasma annealing"

## Beschreibung

Die Erfindung betrifft ein Verfahren zur Passivierung von Kristalldefekten oder von Korngrenzen oder von Innerkorndefekten oder von Oberflächen bei einem elektrisch leitenden Material nach dem Oberbegriff des Anspruchs 1.

Bei polykristallinem Silicium muß im Gegensatz zum monokristallinen Silicium durch das Auftreten von Rekombinationseffekten an Korngrenzen und Innerkorndefekten mit Qualitätseinbußen bei den mit polykristallinem Silicium hergestellten Solarzellen gerechnet werden. In den letzten Jahren wurden verschiedene Verfahren vorgeschlagen, mit denen solche Rekombinationseffekte vermindert bzw. ausgeschaltet werden können. Die meisten dieser Verfahren beruhen darauf, daß die Siliciumscheiben einer wasserstoffhaltigen Atmosphäre ausgesetzt werden. Bei dieser Wasserstoff-Behandlung der Siliciumscheiben können Si-H$_x$-Bindungen entstehen, welche die "dangling bonds" an Korngrenzen und an Innerkorndefekten passivieren. Die effektive Diffusionslänge der Ladungsträger wird dadurch größer und die Lebensdauer der Minoritäts-Ladungsträger verbessert sich. Dies bedeutet, daß die Lichtausbeute einer mit einer solchen Siliciumscheibe hergestellten Solarzelle größer wird.

Bekannte Wasserstoff-Passivierungsverfahren beruhen auf:

a) Wasserstoff-Ionenbeschuß aus einer Kaufmann-Ionenquelle auf ein kaltes oder beheiztes Substrat,

b) Einwirkung eines Hochfrequenz-Wasserstoff-Gasentladungs-Plasmas auf ein kaltes oder beheiztes Substrat,

c) Einwirkung eines DC-Wasserstoff-Gasentladungs-Plasmas auf ein kaltes oder beheiztes Substrat,

d) Behandlung eines Substrats in einer molekularen Wasserstoff-Atmosphäre bei Temperaturen um 600 °C.

Der vorliegenden Erfindung liegt die Aufgabe zugrunde, ein Verfahren der eingangs genannten Art weiter zu verbessern.

Diese Aufgabe wird erfindungsgemäß durch ein Verfahren nach dem Anspruch 1 gelöst.

Bei der Erfindung wirkt auf ein HF-Wasserstoff-Gasentladungs-Plasma eine überlagerte Gleichspannung ein, die zur Beschleunigung der Wasserstoff-Ionen in Richtung auf ein Substrat hin dient. Das Verfahren nach der Erfindung verbindet die Vorteile der Behandlung eines Substrats im reinen Plasma (Ionendichte) mit den Vorteilen der Ionenimplantation (hohe Ionenenergie). Das Substrat bzw. mehrere Substrate befinden sich vorteilhafterweise auf einer das Plasma begrenzenden Elektrode der Prozeßkammer.

Die wesentlichen Vorteile eines Verfahrens nach der Erfindung bestehen in der Möglichkeit einer großflächigen und geometrieunabhängigen Substratbehandlung, in der Möglichkeit einer hohen Ionenstromdichte und in der Möglichkeit von kurzen Prozeßzeiten. Die verwendeten Ionenenergien sind mittels der angelegten Gleichspannung einstellbar. Bei einem Verfahren nach der Erfindung werden die Substrate durch den Ionenbeschuß automatisch aufgeheizt, so daß gegebenenfalls auf eine zusätzliche Beheizung verzichtet werden kann.

Mit einem Verfahren nach der Erfindung konnte bei Experimenten eine Wasserstoffpassivierung von Korngrenzen und von Innerkorndefekten sowohl in mono- als auch in polykristallinen Silicium-Solarzellen erreicht werden.

Ein Verfahren nach der Erfindung ist auch in anderen Fällen, z. B. bei der Passivierung von Kristalldefekten in anderen Materialien, anwendbar.

Experimentelle Untersuchungen zeigen, daß beispielsweise schon nach einer 4 Minuten langen Wasserstoff-Behandlung bei einer 100 × 100 mm großen SILSO-Solarzelle ("SILSO: Warenzeichen), welche eine normale Qualität aufweist, eine relative Wirkungsgradverbesserung von zirka 15 % zu erreichen ist. Bei einem Solarzellenmodul mit 36 Solarzellen, welches eine AR ("Anti-Reflecting") - Vergütung aufweist, konnte nach einer Wasserstoff-Behandlung gemäß der Erfindung ein e Leistung von zirka 41 Watt erzielt werden. Die mit einem Verfahren nach der Erfindung erzielte Passivierung bleibt auch bei einer Temperaturbelastung einer Solarzelle von 300 °C erhalten. Kurzzeitige Temperaturbelastungen von 400 °C führen zu keiner Verminderung einer erfindungsgemäß erzielten Passivierung.

Mit einer Wasserstoff-Behandlung nach der Erfindung ist es möglich, die Qualität von versetzungsbehafteten monokristallinen Materialien, beispielsweise von Solarzellen, zu verbessern. Dabei konnten experimentell relative Wirkungsgradverbesserungen von bis zu 20 % erzielt werden.

Ein Verfahren nach der Erfindung beruht auf einer Kombination von Plasmaätzverfahren und von Ionenimplantation. Die in einem Wasserstoff-Plasma erzeugten Wasserstoff-Ionen werden durch das Anlegen einer Gleichspannung beschleunigt und auf das zu passivierende Material gelenkt. Im Vergleich zu anderen Passivierungsverfahren ist die Prozeßdauer bei einem Verfahren nach der Erfindung viel kürzer und ist damit die thermische und sonstige Belastung der zu passivierenden Materialien kleiner.

Die Erfindung wird anhand der Zeichnung näher erläutert.

Figur 1 zeigt eine Vorrichtung zur Durchführung eines erfindungsgemäßen Verfahrens.

Figuren 2 bis 10 zeigen Verbesserungen von Materialparametern bei Anwendung eines erfindungsgemäßen Verfahrens.

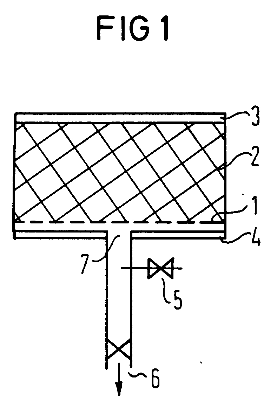

Figur 1 zeigt eine Vorrichtung zur Durchführung eines erfindungsgemäßen Verfahrens. Das erfindungsgemäße Verfahren arbeitet entweder mit einem eingekoppelten Hochfrequenz-$H_2$-Plasma 2 oder mit einem fremderregten Hochfrequenz-$H_2$-Plasma 2, wobei im zuletzt genannten Fall das elektromagnetische Feld zur Plasmaerzeugung und das die Zugspannung zum Beschleunigen von Wasserstoff-Ionen auf ein Substrat 1 bildende elektrische Feld getrennt voneinander regelbar sind. Damit ist es möglich, Ionenenergie und Ionenstrom im Hinblick auf eine optimale Passivierung hin und in Abhängigkeit vom Aufbau der Vorrichtung nach Figur 1 in gewissen Grenzen unabhängig voneinander einzustellen.

Das kapazitiv oder induktiv erregte Hochfrequenz-Wasserstoff-Plasma wird in einem Wasserstoff-Gas erzeugt, und die Wasserstoffionen werden auf ein Target hin beschleunigt, das die zu passivierenden Substrate 1 trägt. Diese Substrate 1 können auf dem Target flach aufgelegt oder hochstehend angeklemmt sein.

Anode 3 und Kathode 4 dienen zum Anlegen der Gleichspannung. Die Substrate 1 sind auf der das Plasma begrenzenden Kathode 4 angeordnet.

Die Vorrichtung nach Figur 1 enthält beispielsweise einen Behälter, der aus einem Glasrezipienten mit einem zylindrischen Mantel, einem Deckel und einem Boden besteht. In diesem Behälter wird das Wasserstoff-Plasma 2 induktiv durch eine Hochfrequenzspule angeregt, die um den zylindrischen Mantel gewickelt ist. Zwischen dem Deckel, der elektrisch vom Mantel isoliert ist, und der Kathode 4 liegt die dem Plasma zu überlagernde Gleichspannung. Die Kathode 4 ist dabei über eine in der Figur 1 nicht dargestellte elektrische Durchführung mit einer außerhalb des Behälters angeordneten Spannungsquelle verbunden. Eine Öffnung 7 führt durch die Kathode 4 hindurch in den Innenraum des Behälters. Über diese Öffnung 7 kann mittels eines Einlasses 5 $H_2$-Gas in den Innenraum des Behälters eingelassen werden. Über die Öffnung 7 kann mittels der Pumpe 6 der Innenraum des Behälters evakuiert werden.

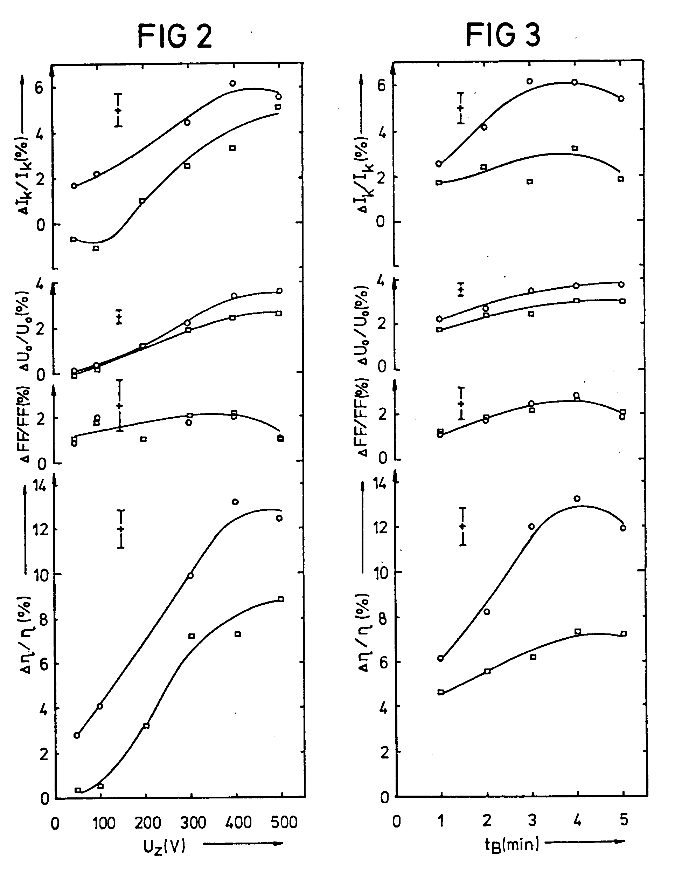

Die Figuren 2 bis 10 zeigen den Einfluß einer Wasserstoffbehandlung nach der Erfindung auf elektrisch leitende Materialien.

Für die Experimente wurden polykristalline SILSO-Silicium-Scheiben und monokristalline SETEK-Silicium-Scheiben verwendet (SETEK" : Fitmenname). Das SILSO-Material hatte einen spezifischen Widerstand von 2 ... 3 Ohm•cm, die SETEK-Scheiben dagegen einen spezifischen Widerstand von 1,0 ... 1,5 Ohm•cm. Alle untersuchten Silicium-Scheiben, die eine Größe von 100 × 100 mm bzw. 50 × 50 mm aufwiesen, wurden in einem Standard-Phosphordi ffusionsprozeß mit einem flachen kleinen p-n-Übergang versehen. Zur Metallisierung der Silicium-Scheiben wurde ein Silber (Ag) -Siebdruckverfahren verwendet, welches für einen Schichtwiderstand von ungefähr 55 Ohm/square ausgelegt ist. Danach wurden die Solarzellen einem Hochfrequenz-Wasserstoff-Plasma ausgesetzt.

Die durch eine Wasserstoff-Behandlung erreichbare Qualitätsverbesserung von Solarzellen ist im wesentlichen von den apparativen Parametern Beschleunigungsspannung $U_z$, Belegzeit $t_B$, Scheibentemperatur und von der Ausgangsqualität der Solarzellen abhängig.

Figur 2 zeigt die relative Verbesserung der Solarzellenparameter in Abhängigkeit von der Beschleunigungsspannung $U_z$ bei einer festen Belegzeit $t_B$ von 3 Minuten.

Figur 3 zeigt die relative Verbesserung der Solarzellenparameter in Abhängigkeit von der Belegzeit $t_B$ bei einer festen Beschleunigungsspannung $U_z$ von 400 V.

In den Figuren 2 und 3 sind mit Kreisen Meßwerte für normales Ausgangsmaterial und mit Quadraten Meßwerte für gutes Ausgangsmaterial gekennzeichnet. Bei den einzelnen Meßkurven-Paaren sind jeweils mit einem Kreuz typische Fehlerbalken angegeben.

Für die Abhängigkeit von der Beschleunigungsspannung $U_z$ ergibt sich folgender Verlauf: solange die Beschleunigungsspannung $U_z$ Werte zwischen 50 V und 500 V aufweist, wobei Ionenstromdichten zwischen 1,7 mA/cm$^2$ und 2 mA/cm$^2$ vorliegen, verbessern sich die Zellenkenndaten mit Zunahme der Beschleunigungsspannung $U_z$. Ab einer Beschleunigungsspannung von etwa 400 V stellt sich ein Sättigungsverhalten ein. Ein ähnlicher Kurvenverlauf ist auch bei der Abhängigkeit von der Belegzeit $t_B$ feststellbar. Bei einer Belegzeit $t_B$ von etwa 4 Minuten liegt eine Sättigung bzw. andeutungsweise ein Maximum vor.

In den Figuren 2 bis 7 sind als Solarzellen-Kenndaten die Leerlaufspannung $U_o$, der Kurzschlußstrom $I_K$, der Füllfaktor FF und der Wirkungsgrad Eta dargestellt.

Das aus den Figuren 2 und 3 ersichtliche Verhalten der Meßkurven ist wahrscheinlich eine Folge der Temperaturabhängigkeit von Wasserstoff-Diffusionsprozessen. Bei den beschriebenen Versuchen konnte bei einer Beschleunigungsspannung $U_z$ von 400 V und bei einer Belegzeit $t_B$ von 4 Minuten an der Rückseite einer Silicium-Scheibe eine maximale Temperatur von zirka 400 °C gemessen werden. Die größte erreichbare effektive Diffusionslänge betrug dabei 60 $\mu$m.

Bei großen Belegzeiten können sich Absputterprozesse am Silicium und an der Metallisierung negativ bemerkbar machen. Bei größeren Beschleunigungsspannungen $U_z$ nimmt das Plasmablitzen an der Metallisierung und damit die Gefahr der Löcherbildung an der Siliciumscheibe zu. Als optimale Parameterwerte bei den verwendeten Silicium-Scheiben wurden eine Beschleunigungsspannung $U_z$ von 400 V und eine Belegzeit $t_B$ von 4 Minuten ermittelt.

Versuche haben ergeben, daß die Qualitätsverbesserung von Solarzellen nicht wesentlich vom Wasserstoff-Gasdruck $P_H$ und von der Hochfrequenzspannung $U_{HF}$ beeinflußt wird. Die Wahl der optimalen $U_{HF}$- und $P_H$-Werte wird deshalb im Wesentlichen von der Stabilität des Plasmabrennens und der Reproduzierbarkeit des Prozesses bestimmt. Als geeignete Werte haben sich eine Hochfrequenzspannung $U_{HF}$ von 2,5 kV und ein Wasserstoff-Gasdruck $P_H$ von 0,1 Pa ($7,6 \times 10^{-4}$ Torr) erwiesen.

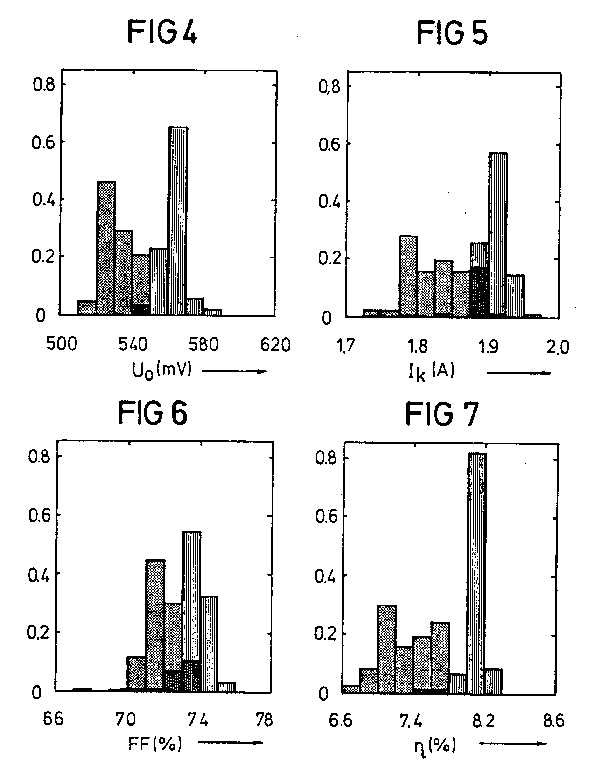

In den Figuren 2 und 3 ist bei den Meßkurven bis auf den Füll faktor FF eine deutliche Trennung zwischen normalem und gutem Ausgangsmaterial (SILSO-Rohmaterial) erkennbar. Neben der Qualitätssteigerung bewirkt die Wasserstoff-Behandlung auch eine Einengung der Qualitätsstreuung. Damit kann die Ausbeute für die besseren Qualitätsklassen erhöht werden, wie dies anhand der Figuren 4 bis 7 dargestellt ist.

In den Figuren 4 bis 7 ist die Verteilung von Solarzellen-Kenndaten vor der Wasserstoff-Behandlung mit einem gepunkteten Histogramm und nach der Wasserstoff-Behandlung mit einem vertikal schraffierten Histogramm dargestellt.

Figur 4 zeigt die Verteilung der Leerlaufspannung $U_o$.

Figur 5 zeigt die Verteilung für den Kurzschlußstrom $I_K$.

Figur 6 zeigt die Verteilung für den Füllfaktor FF.

Figur 7 zeigt die Verteilung für den Wirkungsgrad Eta.

Den Darstellungen der Figuren 4 bis 7 wurde jeweils die gleiche Menge von 83 Solarzellen zugrunde gelegt. Diese Solarzellen waren $100 \times 100$ mm-SILSO-Solarzellen. Diese Solarzellen wiesen keine AR-Schicht auf.

Solarzellen aus polykristallinem Silicium weisen nach einer Wasserstoffpassivierung gemäß der Erfindung eine Leistung auf, welche nahe an die Leistung von vergleichbaren Solarzellen aus monokristallinem Silicium heranreicht.

Wasserstoff-passivierte Zellen wurden 1 Stunde lang einer Temperatur von 300 °C ausgesetzt, ohne daß die Passivierung beeinflußt wurde. Bei normalen Betriebsbedingungen, bei denen eine maximale Temperatur von 95 °C zu erwarten ist, kann davon ausgegangen werden, daß eine Verschlechterung der Passivierung nicht auftreten wird.

Unter Standardbedingungen wurden versetzungsbehaftete monokristalline Silicium-SETEK-Solarzellen einer Wasserstoff-Behandlung unterworfen. Auch bei diesen Zellen ist eine starke Anhebung der Solarzellenparameter feststellbar. Die Qualitätsverbesserung stammt dabei allein von der Passivierung von Versetzungen. Diese Versetzungen konnten durch eine SIRTL-Ätzung optisch sichtbar gemacht werden.

Die Dämpfung der spektralen Empfindlichkeit einer polykristallinen Solarzelle hängt im Wesentlichen von der Korngrenzen-Rekombinationsgeschwindigkeit, von der "bulk" -Diffusionslänge und von der Korngröße ab. Diese Parameter machen sich jedoch erst bei langwelligem Licht bemerkbar.

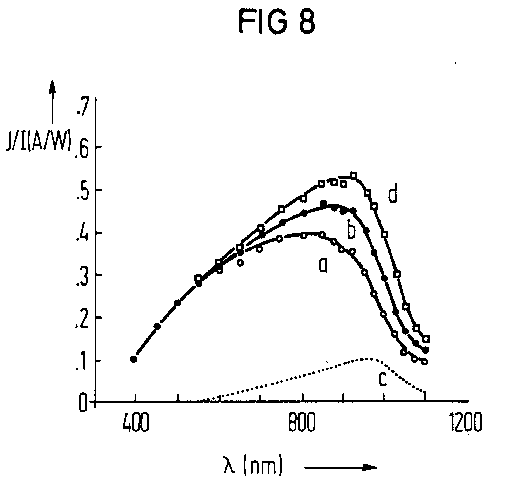

Figur 8 zeigt die spektrale Empfindlichkeit für $100 \times 100$ mm große Solarzellen, welche keine AR-Schicht aufweisen. Die Kurve a repräsentiert eine polykristalline SILSO-Solarzelle vor der Wasserstoff-Behandlung. Die effektive Diffusionslänge L beträgt dabei 39 $\mu$m. Die Kurve b stellt die Messung an einer SILSO-Solarzelle nach Wasserstoff-Behandlung dar. Die effektive Diffusionslänge beträgt dabei 57 $\mu$m. An der Kurve c läßt sich der Zugewinn durch die Wasserstoff-Behandlung ablesen, welcher beim Übergang von der Kurve a zur Kurve b erzielt wird. Die Kurve d ist typisch für eine vergleichbare monokristalline Referenz-Solarzelle, bei welcher die Diffusionslänge L einen Wert von 116 $\mu$m aufweist.

Durch die Wasserstoff-Behandlung werden die Rekombinationsverluste herabgesetzt, die effektive Diffusionslänge steigt und das Photostromniveau wird angehoben. Der Zugewinn des Photostromes infolge der Wasserstoff-Behandlung nimmt ab einer Wellenlänge von 550 nm stetig zu und erreicht bei einer Wellenlänge von 970 nm ein Maximum. Bei der Wellenlänge von 970 nm macht sich die effektive Diffusionslänge bemerkbar und der Photostrom und dessen Zugewinn nehmen ab.

Für kurze Wellenlängen, z. B. 400 nm bis 500 nm, werden die Ladungsträger in der Nähe der $n^+$-Schicht erzeugt. Die Photostromerzeugung in dieser diffundierten Zone verhält sich ähnlich wie in einer monokristallinen Silicium-Solarzelle.

Für Wellenlängen von 600 nm bis 700 nm werden die Ladungsträger meistens in der Basisregion der Zelle nahe des $n^+$-p-Übergangs erzeugt, wodurch die meisten Ladungsträger den Übergang zur Stromerzeugung erreichen. Die Photostromdämpfung macht sich bei diesen Wellenlängen noch nicht bemerkbar.

Für Wellenlängen von 700 nm bis 1000 nm werden die Ladungsträger im "bulk" der Zelle erzeugt, fern vom $n^+$-p-Übergang. Die Wahrscheinlichkeit, daß "bulk"-Rekombinationsefekte und Korngrenzenrekombinationseffekte an diesen Ladungsträgern erfolgen können, nehmen zu und die Dämpfung des Photostromes kommt stärker zum Tragen.

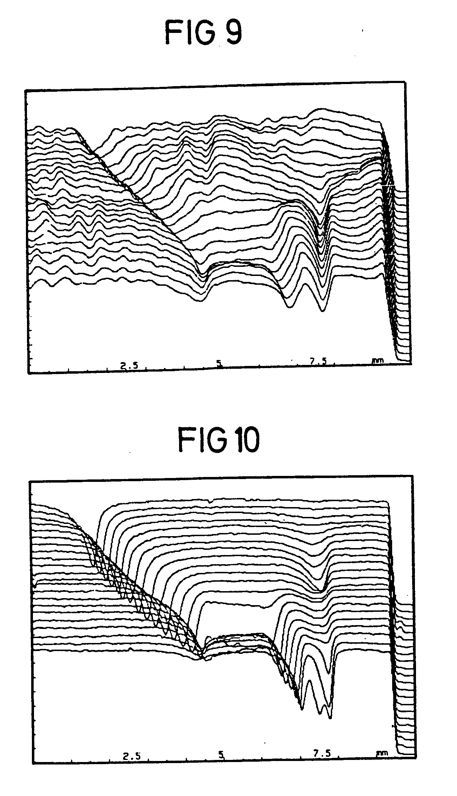

Die Figuren 9 und 10 zeigen ortsaufgelöste Messungen der Photostromempfindlichkeit bei einer Wellenlänge von 899 nm an polykristallinen SILSO-Solarzellen vor der Wasserstoff-Behandlung (Figur 9) und nach der Wasserstoff-Behandlung (Figur 10). Diese ortsaufgelösten Messungen der Photostromempfindlichkeit zeigen, daß das elektrische Erscheinungsbild der Korngrenzen durch Täler und das der Innerkorndefekte durch eine Kurvenwelligkeit charakterisiert ist.

Die in Figur 10 dargestellte Photoempfindlichkeit nach der Wasserstoff-Behandlung läßt erkennen, daß die Kurvenwelligkeit verschwunden ist, was auf die Passivierung der Innerkorndefekte zurückzuführen ist. An einigen Korngrenzen ist deutlich eine Verringerung der Rekombinationsverluste erkennbar, weil dort die Talstruktur geglättet worden ist. Andere Korngrenzen dagegen weisen eine verstärkte glockenförmige Talstruktur mit unverändertem Talsohlenniveau auf. Die Korngrenze wirkt hier als Ladungsträgerquelle, deren Generationsrate durch eine Wasserstoff-Behandlung nicht gesteigert werden kann.

Mit einem Verfahren nach der Erfindung können Korngrenzen und Innerkorndefekte bei polykristallinen Materialien, irgendwelche Kristalldefekte bei monokristallinen Materialien und irgendwelche lokale Störzentren oder sonstige Rekombinationszentren bei amorphen Materialien passiviert werden. Mit einem Verfahren nach der Erfindung können auch beliebige Oberflächen von beliebigen Materialien passiviert werden.

**Patentansprüche**

1. Verfahren zur Passivierung von Kristalldefekten oder von Korngrenzen oder von Innerkorndefekten oder von Oberflächen bei einem elektrisch leitenden Material in einem Plasma, wobei zur Passivierung Wasserstoff-Ionen auf das elektrisch leitende Material einwirken, **dadurch gekennzeichnet,** daß auf ein Hochfrequenz-Wasserstoff-Gasentladungsplasma eine überlagerte Gleichspannung einwirkt, die zur Beschleunigung der Wasserstoff-Ionen auf das elektrisch leitende Material hin dient.

2. Verfahren nach Anspruch 1, **dadurch gekennzeichnet,** daß polykristallines Material passiviert wird.

3. Verfahren nach Anspruch 1, **dadurch gekennzeichnet,** daß monokristallines Material passiviert wird.

4. Verfahren nach Anspruch 1, **dadurch gekennzeichnet,** daß die Oberfläche eines elektrisch leitenden Materials passiviert wird.

5. Verfahren nach einem der Ansprüche 1 bis, 4 **dadurch gekennzeichnet,** daß das elektrisch leitende Material auf einer das Plasma begrenzenden Gleichspannungs-Elektrode angeordnet wird.

6. Verfahren nach einem der Ansprüche 1 bis 5, **dadurch gekennzeichnet,** daß die Ionenenergien mittels der angelegten Gleichspannung so eingestellt werden, daß auf eine zusätzliche Substratheizung verzichtet werden kann.

**Claims**

1. Process for the passivation of crystal defects or of grain boundaries or of internal grain defects or surfaces in an electrically conductive material in a plasma, hydrogen ions acting on the electrically conductive material to effect passivation, characterised in that a superimposed d.c. voltage which is used for accelerating the hydrogen ions towards the electrically conductive material acts on a high-frequency hydrogen gas discharge plasma.

2. Process according to Claim 1, characterised in that polycrystalline material is passivated.

3. Process according to Claim 1, characterised in that monocrystalline material is passivated.

4. Process according to Claim 1, characterised in that the surface of an electrically conductive material is passivated.

5. Process according to any of Claims 1 to 4, characterised in that the electrically conductive material is arranged on a d.c. electrode which delimits the plasma.

6. Process according to any of Claims 1 to 5, characterised in that the ion energy levels are set by means of the connected d.c. voltage so as to make it possible to dispense with additional substrate heating.

**Revendications**

1. Procédé de passivation d'imperfections cristallines ou de joints de grains ou d'imperfections à l'intérieur des grains ou de surface d'un matériau électriquement conducteur dans un plasma par action, pour la passivation, d'ions hydrogène sur le matériau électriquement conducteur,
caractérisé
en ce qu'il consiste à faire agir, sur un plasma à décharge gazeuse et à hydrogène en haute fréquence, une tension continue superposée qui sert à accélérer les ions hydrogène en direction du matériau conducteur de l'électricité.

2.  Procédé suivant la revendication 1,
caractérisé
en ce qu'il consiste à passiver du matériau polycristallin.

3.  Procédé suivant la revendication 1,
caractérisé
en ce qu'il consiste à passiver du matériau monocristallin.

4.  Procédé suivant la revendication 1,
caractérisé
en ce qu'il consiste à passiver la surface d'un matériau électriquement conducteur.

5.  Procédé suivant l'une des revendications 1 à 4,
caractérisé
en ce que le matériau électriquement conducteur est disposé sur une électrode de tension continue délimitant le plasma.

6.  Procédé suivant l'une des revendications 1 à 5,
caractérisé
en ce qu'il consiste à régler l'énergie des ions au moyen de la tension continue appliquée de façon à pouvoir se dispenser d'un chauffage supplémentaire du substrat.

# FIG 1

# FIG 2

# FIG 3

# FIG 4

# FIG 5

# FIG 6

# FIG 7

# FIG 8

# FIG 9

# FIG 10